# EUROPÄISCHE PATENTSCHRIFT

(11) **EP 2 140 508 B1**
(45) Veröffentlichungstag und Bekanntmachung des Hinweises auf die Patenterteilung: **17.11.2010**
(21) Anmeldenummer: 08718215.0
(22) Anmeldetag: 26.03.2008
(51) Int. Cl.: H01L 41/083, H01L 41/24

(54) **PIEZOELEKTRISCHES BAUTEIL MIT SICHERHEITSSCHICHT UND INFILTRATIONSBARRIERE UND VERFAHREN ZU DESSEN HERSTELLUNG**
PIEZOELECTRIC COMPONENT COMPRISING A SECURITY LAYER AND AN INFILTRATION BARRIER AND A METHOD FOR THE PRODUCTION THEREOF
COMPOSANT PIÉZOÉLECTRIQUE COMPORTANT UNE COUCHE DE SÉCURITÉ ET UNE BARRIÈRE D'INFILTRATION, ET SON PROCÉDÉ DE PRODUCTION

(30) Priorität: 30.03.2007 DE 102007015446
(43) Veröffentlichungstag der Anmeldung: 06.01.2010
(73) Patentinhaber: Siemens Aktiengesellschaft, 80333 München (DE)
(72) Erfinder: DENZLER, Michael, 93055 Regensburg (DE); HAMANN, Christoph, 93107 Thalmassing (DE); KASTL, Harald Johannes, 95686 Fichtelberg (DE); KOHN, Stefan, 92277 Hohenburg (DE); KRONBERGER, Maximilian, 4400 Steyr (AT); REICHINGER, Christian, 93073 Neutraubling (DE); SCHUH, Carsten, 85598 Baldham (DE); ZUMSTRULL, Claus, 93128 Regenstauf (DE)
(86) Internationale Anmeldenummer: PCT/EP2008/053540
(87) Internationale Veröffentlichungsnummer: WO 2008/119702

(56) Entgegenhaltungen:
- EP-A- 1 764 844
- WO-A-03/105246
- WO-A-2006/131106
- DE-A1- 10 307 825
- DE-A1-102004 031 404
- DE-A1-102004 050 803

## Beschreibung

Die Erfindung betrifft ein piezoelektrisches Bauteil mit einem monolithischen Stapel, aufweisend abwechselnd übereinander angeordnete Elektrodenschichten und Piezokeramikschichten mit einer Piezokeramik und mindestens eine im Stapel angeordnete poröse Sicherheitsschicht zur Bildung eines Risses bei mechanischer Überlastung des Stapels. Daneben wird ein Verfahren zum Herstellen des Bauteils angegeben.

Das piezoelektrische Bauteil ist ein keramischer Piezoaktor in monolithischer Vielschichtbauweise. Derartige Vielschichtaktoren weisen in einigen Ausführungsformen poröse, keramische oder metallische Sicherheitsschichten (Sicherheitsstrukturen) auf. Die porösen Sicherheitsschichten fungieren als Sollbruchstellen: Bei mechanischer Überlastung des Stapels des Piezoaktors kommt es vornehmlich in diesen Sicherheitsschichten zur Bildung von Rissen (Polungsrisse). Dadurch ist eine Lagedefinition und Führung der bei einer Polung oder im Betrieb entstehenden Polungsrisse möglich. Diese Sicherheitsschichten können von Keramikschichten oder von Elektrodenschichten (Innenelektroden) erhöhter Porosität gebildet werden.

Zur elektrischen Kontaktierung sind die Innenelektroden abwechselnd an von einander elektrisch isolierte, seitliche Oberflächenabschnitte des Stapels geführt. An diesen Oberflächenabschnitten sind Metallisierungen (Außenmetallisierungen) angebracht. Über diese Metallisierungen sind die Innenelektroden alternierend elektrisch parallel geschaltet.

Der Stapel des Piezoaktors ist mit einer Kunststoffummantelung aus Silikon versehen. Diese Kunststoffummantelung dient einer Passivierung des Stapels. Dies bedeutet: Durch die Kunststoffummantelung sind die bis an die seitlichen Oberflächen des Stapels reichenden Innenelektroden elektrisch isoliert und vor mechanischer Zerstörung geschützt.

Beim Aufbringen der Metallisierung und beim Aufbringen des Silikons auf die Oberfläche des Stapels kann es zum Eindringen von Metall, geschmolzenem Glas (Haftvermittler der Metallisierung) und Silikonbestandteilen in die poröse Sicherheitsschicht kommen. Es findet eine Infiltration der genannten Stoffe statt. Infolge dieser Infiltration kann eine ungewollte elektrische Leitfähigkeit der Sicherheitsschicht oder eine mechanische Kerbwirkung im Riss entstehen, was eine Schädigung der Sicherheitsschicht sowie einer Umgebung der Sicherheitsschicht mit sich bringen kann. Ein vorzeitiger Ausfall des Bauteils könnte die Folge sein.

Aus dem Stand der Technik sind Aktoren mit porösen Sicherheitsschichten bekannt (zum Beispiel aus der DE 10 2004 050 803 A1). Zur Verhinderung des Eindringens von Fremdstoffen in diese Sicherheitsschichten ist zum Beispiel aus der WO 03/105246 bekannt, die Außenmetallisierung zusammen mit dem Sintern des Stapels aufzubrennen, so dass das Metall der Außenmetallisierung nicht in bei der Polarisierung eventuell auftretende Risse eindringen kann. Alternativ wird in der DE 103 07 825 A1 vorgeschlagen, die porösen Bereiche durch geeignete Elektrodenkonfigurationen feldfrei zu halten, so dass damit das Eindringen von Feuchtigkeit und Schmutz verhindert wird.

Aufgabe der vorliegenden Erfindung ist es, ein Eindringen von Fremdmaterial in die poröse Sicherheitsschicht während einer Herstellung eines piezoelektrischen Bauteils mit einem monolithischen Stapel zu verhindern.

Zur Lösung der Aufgabe wird ein piezoelektrisches Bauteil mit einem monolithischen Stapel angegeben, aufweisend abwechselnd übereinander angeordnete Elektrodenschichten und Piezokeramikschichten mit einer Piezokeramik und mindestens eine im Stapel angeordnete poröse Sicherheitsschicht zur Bildung eines Risses bei mechanischer Überlastung des Stapels. Das piezoelektrische Bauteil ist dadurch gekennzeichnet, dass zwischen der Sicherheitsschicht und einem seitlichen Oberflächenabschnitt des Stapels eine Infiltrationsbarriere zur Unterdrückung eines Eindringens eines Fremdstoffes in die Sicherheitsschicht angeordnet ist.

Zur Lösung der Aufgabe wird auch ein Verfahren zum Herstellen des Stapels des piezoelektrischen Bauteils mit folgenden Verfahrensschritten angegeben: a) Abwechselndes übereinander Anordnen von keramischen Grünfolien und Metallschichten zu einem Grünfolienverbund, wobei in den Grünfolienverbund mindestens eine Ausgangsschicht der Sicherheitsschicht integriert wird und b) Wärmebehandeln des Grünfolienverbunds zum monolithischen Stapel, wobei aus den keramischen Grünfolien die Piezokeramikschicht, aus den Metallschichten die Elektrodenschichten und aus der Ausgangsschicht der Sicherheitsschicht die Sicherheitsschicht entstehen und die Infiltrationsbarriere gebildet wird.

Die grundlegende Idee der Erfindung besteht darin, die poröse Sicherheitsschicht vor dem Eindringen von Fremdstoffen zu schützen. Dies gelingt mit der Infiltrationsbarriere. Die Infiltrationsbarriere bildet einen Rand des Stapels. Die Infiltrationsbarriere weist vorzugsweise keine offene Porosität auf. Dadurch wird verhindert, dass Fremdstoffe eindringen können. Die Infiltrationsbarriere stellt einen dichten Randbereich dar.

In einer besonderen Ausgestaltung umrandet die Infiltrationsbarriere die Sicherheitsschicht. Die Sicherheitsschicht ist nicht vollflächig über einen gesamten Stapelquerschnitt ausgebildet. Es verbleibt ein schmaler, umlaufender Randbereich zu den seitlichen Oberflächen des Stapels hin.

In einer weiteren Ausgestaltung ist die Infiltrationsbarriere in einem piezoelektrisch inaktiven Kontaktierungsbereich des Stapels angeordnet. Im Kontaktierungsbereich ist jede zweite Innenelektrode an einen gemeinsamen seitlichen Oberflächenabschnitt geführt. Dort findet die elektrische Kontaktierung der Innenelektroden über die am Oberflächenabschnitt angebrachte Außenmetallisierung statt. Es ist eine kammartige Struktur der Innenelektroden ausgebildet. Man spricht auch von einer so genannten Mehrschichtkondensator-Struktur. Diese Art der Kontaktierung führt dazu, dass im Kontaktierungsbereich ein im Vergleich zum piezoelektrisch aktiven Bereich, der direkt zwischen Elektrodenschichten unterschiedlicher Polarität liegt, deutlich unterschiedliches elektrisches Feld in die Piezokeramik eingekoppelt wird. Dies ist der Hauptgrund für die während der Polung und während des Betriebs auftretende Rissbildung.

Im Kontaktierungsbereich kann es ohne Infiltrationsbarriere während des Aufbringens der Metallisierung zum Eindringen von Fremdstoffen in die poröse Sicherheitsschicht kommen. Beispielsweise dringt elektrisch leitfähiges Material der Metallisierung ein. Die Folge wäre eine nicht gewollte elektrische Leitfähigkeit im Kontaktierungsbereich. Eine Funktionsfähigkeit des Bauteils könnte nicht gewährleistet werden. Durch die Infiltrationsbarriere wird aber verhindert, dass das elektrisch leitfähige Material eindringen kann. Die Funktion des Bauteils ist sicher gestellt.

Vorzugsweise weist die Infiltrationsbarriere dabei eine Abmessung auf, die kleiner ist als die Abmessung des Kontaktierungsbereichs. Die Infiltrationsbarriere bildet den Rand des Kontaktierungsbereichs hin zum seitlichen Oberflächenabschnitt, an dem die Metallisierung angebracht ist. Die Abmessung der Infiltrationsbarriere ist beispielsweise eine Tiefe der Infiltrationsbarriere. Eine Tiefe des Kontaktierungsbereichs ist größer als die Tiefe des Infiltrationsbereichs. Vorzugsweise ist die Tiefe des Kontaktierungsbereichs deutlich größer als die Tiefe der Infiltrationsbarriere. Beispielsweise beträgt das Verhältnis der Tiefe des Kontaktierungsbereichs und der Tiefe der Infiltrationsbarriere vier und mehr.

Dadurch, dass nur ein kleiner Randbereich von der Infiltrationsbarriere gebildet ist, werden eine gewünschte Rissinitiierung und ein gewünschter Rissverlauf in der Sicherheitsschicht nicht negativ beeinflusst. Gleichzeitig wird dafür gesorgt, dass Fremdstoffe, beispielsweise flüssige Materialien im Herstellprozess, nicht in die Sicherheitsschicht eindringen und dort Schäden auslösen können.

Gemäß einer besonderen Ausgestaltung des Verfahrens wird zum Bilden der Infiltrationsbarriere das Wärmebehandeln unterbrochen und folgende weiteren Verfahrensschritte durchgeführt: c) Infiltration von Barriere-Material an einem seitlichen Oberflächenabschnitt des teilweise gesinterten Stapels und d) Fortführen der Wärmebehandlung, so dass aus dem Barriere-Material die Infiltrationsbarriere gebildet wird.

Durch das Unterbrechen kann lediglich ein Ansintern des Stapels durchgeführt worden sein, so dass ein teilweise gesinterter Stapel vorliegt. Daneben ist es auch denkbar, das Sintern vollständig durchzuführen und nach dem Sintern, also am fertig gesinterten Stapel, die Infiltration mit anschließender Wärmebehandlung durchzuführen.

Vorzugsweise wird zur Infiltration des Barriere-Materials ein aus der Gruppe Sol-Gel-Verfahren, Schlickerverfahren, Sprühen und Tauchen ausgewähltes Verfahren verwendet. Alternative Techniken sind dabei auch möglich, beispielsweise ein Aufragen des Barriere-Materials per Pinsel.

In einer besonderen Ausgestaltung weist die Infiltrationsbarriere ein zur Piezokeramik arteigenes Barriere-Material auf. Das Barriere-Material ist dabei von derselben Art, wie die Piezokeramik der Grünfolien des Stapelverbundes bzw. die Piezokeramik der Piezokeramikschichten. Beispielsweise wird als Piezokeramik ein Bleizirkonattitanat (PZT) verwendet. Das Barriere-Material ist ebenfalls ein Bleizirkonattitanat. Denkbar ist dabei insbesondere auch der Fall, dass die Barriere-Schicht von der Piezokeramik der angrenzenden Piezokeramikschichten gebildet wird. Alternative Materialien, beispielsweise Zirkoniumoxid, sind ebenfalls denkbar. Wichtig ist, dass durch die Infiltration des Barriere-Materials und anschließende Wärmebehandlung ein dichter Randbereich entsteht, der dazu führt, dass während der Verarbeitung des Stapels keine Infiltration von Fremdstoffen stattfinden kann.

In einer weiteren Ausgestaltung werden vor dem übereinander Anordnen der keramischen Grünfolien und der Metallschichten folgende weiteren Verfahrensschritte durchgeführt: e) Bereitstellen einer keramischen Grünfolie und f) Anordnen der Ausgangsschicht der Sicherheitsschicht. Zum Anordnen der Ausgangschicht wird beispielsweise eine Paste auf die Grünfolie aufgedruckt. Dabei kann so vorgegangen werden, dass die Paste nicht über die gesamte Fläche der Grünfolie aufgebracht wird. Es verbleibt ein Rand. Wenn nun auf dem Verbund Grünfolie-Ausgangsschicht eine weitere Grünfolie angeordnet wird und der resultierende Verbund gesintert wird, verbinden sich die Piezokeramik der Grünfolie und die Piezokeramik der weiteren Grünfolie. Es entsteht eine Infiltrationsbarriere aus der Piezokeramik der angrenzenden Piezokeramikschichten. Das beschriebene Verfahren funktioniert umso besser, je dünner die Ausgangsschicht der Sicherheitsschicht ist.

In einer weiteren Ausgestaltung wird zusätzlich zum Anordnen der Ausgangsschicht der Sicherheitsschicht ein Anordnen einer Vorstufe der Infiltrationsbarriere auf der Grünfolie durchgeführt. Dieses Verfahren eignet sich für den Fall, dass das Barriere-Material der Infiltrationsbarriere sich von der Piezokeramik der Piezokeramikschichten unterscheidet. Aber auch hier kann arteigenes Material verwendet werden.

Das Anordnen der Ausgangsschicht und der Vorstufe erfolgt nach gängigen Verfahren, beispielsweise Siebdruck. Es wird auf der Grünfolie eine Struktur aufgetragen, aus der die Sicherheitsschicht und die Infiltrationsbarriere gebildet werden. Erzeugt werden kann diese Struktur durch ein entsprechendes Bedruckungs- beziehungsweise Maskierungslayout beim Siebdruck oder bei der Abscheidung des (keramischen oder metallischen) Sicherheitsschichtmaterials.

Das beschriebene piezoelektrische Bauteil mit dem Stapel in monolithischer Vielschichtbauweise wird vorzugsweise zum Ansteuern eines Ventils und insbesondere zum Ansteuern eines Einspritzventils einer Brennkraftmaschine verwendet.

Zusammenfassend ergeben sich mit der Erfindung folgende wesentlichen Vorteile:
- Mit Hilfe der Infiltrationsbarriere wird ein Eindringen von Fremdstoffen in eine Sicherheitsschicht während der Herstellung des Stapels des piezoelektrischen Bauteils unterbunden.
- Die Funktion der Sicherheitsschicht, also die Kontrolle von Rissbildung und Risswachstum, bleibt erhalten.
- Unerwünschte Folgen einer Infiltration, beispielsweise eine erhöhte elektrische Leitfähigkeit, werden vermieden.

Anhand mehrerer Ausführungsbeispiele und der dazugehörigen Figuren wird die Erfindung im Folgenden näher beschrieben. Die Figuren sind schematisch und stellen keine maßstabsgetreuen Abbildungen dar.
- Figur 1: zeigt einen monolithischen Stapel eines piezoelektrischen Bauteils von der Seite.
- Figur 2: zeigt einen Schnitt durch den Stapel auf der Höhe einer Sicherheitsschicht.
- Figur 3: zeigt eine weitere Ausführungsform eines Stapels eines piezoelektrischen Bauteils von der Seite.
- Figur 4: zeigt einen Schnitt auf der Höhe einer Sicherheitsschicht.

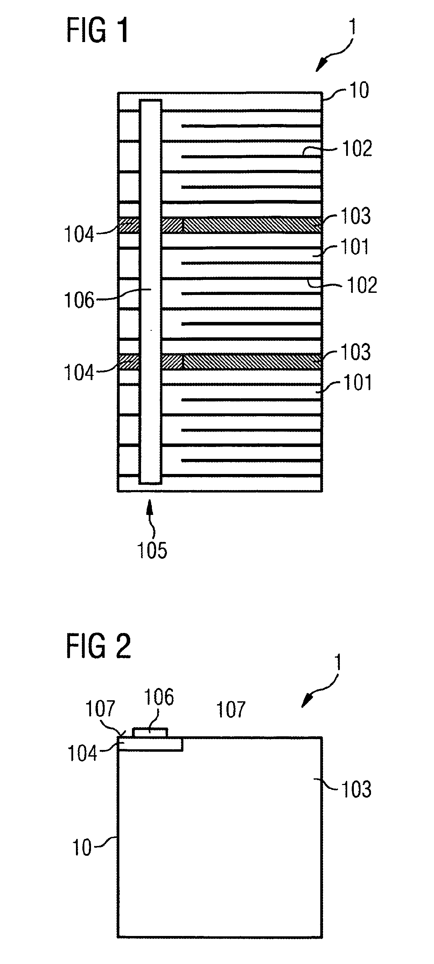

Das piezoelektrische Bauteil 1 ist ein monolithischer Piezoaktor in Vielschichtbauweise (Figuren 1 und 2). Der Piezoaktor in Vielschichtbauweise weist einen Stapel 10 aus abwechselnd übereinander angeordneten Piezokeramikschichten 101 und Elektrodenschichten 102 auf. Die Piezokeramikschichten weisen Bleizirkonattitanat auf. Die Elektrodenschichten werden von einer Palladium-SilberLegierung gebildet. Im Stapel sind poröse Sicherheitsschichten 103 eingebaut. Gemäß einer ersten Ausführungsform ist die Sicherheitsschicht keramischer Natur. In einer dazu alternativen Ausführungsform wird die Sicherheitsschicht von einer Metallschicht gebildet. Bei beiden Ausführungsformen weist die Sicherheitsschicht eine im Vergleich zum Rest des Stapels erhöhte Porosität auf. Dies führt dazu, dass die Sicherheitsschicht als Sollbruchstelle fungiert: Bei mechanischer Überlastung des Stapels treten bevorzugt in dieser Sicherheitsschicht mit der erhöhten Porosität Risse auf. Damit ist die Steuerung der Rissbildung und der Ausbreitung des Risses möglich.

An einem seitlichen Oberflächenabschnitt 107 des Stapels ist eine Metallisierung 106 zur elektrischen Kontaktierung der Elektrodenschichten des Stapels angeordnet. In den Figuren ist jeweils nur eine Metallisierung angedeutet. Tatsächlich ist aber mindestens eine weitere Metallisierung vorhanden. Über die beiden Metallisierungen können die Elektrodenschichten alternierend mit unterschiedlichen elektrischen Potentialen beaufschlagt werden.

Im Kontaktierungsbereich 105 ist zwischen der Sicherheitsschicht 103 und dem seitlichen Oberflächenabschnitt 107 eine Infiltrationsbarriere 104 angeordnet. Zum seitlichen Oberflächenabschnitt des Stapels hin befindet sich die Infiltrationsbarriere. Die Infiltrationsbarriere bildet einen Randbereich des Stapels. Die Infiltrationsbarriere zeichnet sich durch eine erhöhte Dichte auf, so dass ein Eindringen von Fremdstoffen in die poröse Sicherheitsschicht unterbunden wird. Dadurch bleibt die Funktion der Sicherheitsschicht erhalten.

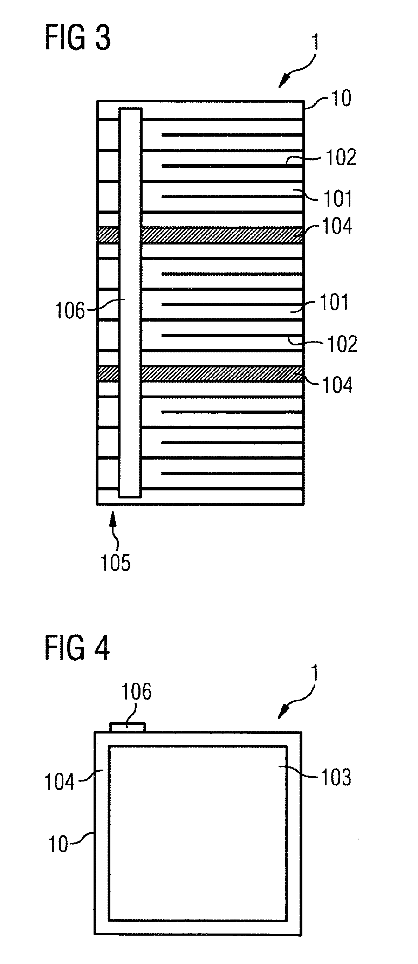

Gemäß einem weiteren Ausführungsbeispiel umrandet die Infiltrationsbarriere komplett die Sicherheitsschicht (Figuren 3 und 4). Die Sicherheitsschicht ist nirgends bis an den seitlichen Oberflächenabschnitt des Stapels geführt.

Zum Herstellen des monolithischen Stapels werden keramische Grünfolien mit Metall bedruckt, übereinander zu einem Grünfolienverbund gestapelt, entbindert und zum monolithischen Stapel gesintert. Die Grünfolien führen zu den Piezokeramikschichten. Aus dem aufgedruckten Metall (Metallschichten) resultieren die Elektrodenschichten. Im Grünfolienverbund wird zudem eine Ausgangsschicht der Sicherheitsschicht integriert, aus der während des Sintervorgangs die Sicherheitsschicht gebildet wird.

Zur Integration der Infiltrationsbarriere wird nach dem Sintern ein Barriere-Material in den Randbereich der nach dem Sintern vorhandenen, porösen Sicherheitsschicht infiltriert. Das Barriere-Material ist arteigenes PZT.

Gemäß einer weiteren Ausführungsform wird der Verbund lediglich angesintert, also nicht vollständig gesintert bzw. verdichtet. Der Sintervorgang wird unterbrochen und das Barriere-Material infiltriert. Nach dem Infiltrieren wird der Sintervorgang fortgesetzt. Dabei bildet sich die Infiltrationsbarriere.

Zur Integration der Infiltrationsbarriere werden gemäß einer alternativen Ausführungsform die Ausgangsschicht der Sicherheitsschicht und eine Vorstufe der Infiltrationsbarriere auf einer Grünfolie aufgebracht. Das Aufbringen erfolgt durch Siebdruck. Die bedruckte Grünfolie wird zusammen mit anderen Grünfolien gestapelt, laminiert, entbindert und gesintert. Während dieser Wärmebehandlung entsteht aus der Vorstufe die Infiltrationsbarriere.

Einer weiteren Ausführungsform entsprechend wird auf das Anordnen der Vorstufe der Infiltrationsbarriere verzichtet. Es wird die Grünfolie lediglich mit einer dünnen Ausgangsschicht der Sicherheitsschicht bedruckt, wobei ein Randbereich der Grünfolie unbedruckt bleibt. Anschließendes Stapeln mit weiteren Grünfolien und Sintern führt dazu, dass sich die Piezokeramik der Grünfolie und der einer direkt angrenzenden benachbarten Grünfolie verbinden. Es entsteht eine Infiltrationsbarriere aus der Piezokeramik der Piezokeramikschichten.

## Patentansprüche

1. Piezoelektrisches Bauteil (1) mit einem monolithischen Stapel (10), aufweisend
- abwechselnd übereinander angeordnete Elektrodenschichten (102) und Piezokeramikschichten (101) mit einer Piezokeramik und
- mindestens eine im Stapel (10) angeordnete poröse Sicherheitsschicht (103) zur Bildung eines Risses bei mechanischer Überlastung des Stapels (10),
**dadurch gekennzeichnet, dass**
- zwischen der Sicherheitsschicht (103) und einem seitlichen Oberflächenabschnitt (107) des Stapels (10) eine Infiltrationsbarriere (104) zur Unterdrückung eines Eindringens eines Fremdstoffes in die Sicherheitsschicht (103) angeordnet ist.

2. Bauteil nach Anspruch 1, wobei die Infiltrationsbarriere (104) die Sicherheitsschicht (103) umrandet.

3. Bauteil nach Anspruch 1 oder 2, wobei die Infiltrationsbarriere (104) in einem piezoelektrisch inaktiven Kontaktierungsbereich (105) des Stapels (10) angeordnet ist.

4. Bauteil nach Anspruch 3, wobei die Infiltrationsbarriere (104) eine Abmessung aufweist, die kleiner ist als eine Abmessung des Kontaktierungsbereichs (105).

5. Bauteil nach einem der Ansprüche 1 bis 4, wobei die Infiltrationsbarriere (104) ein zur Piezokeramik arteigenes Barriere-Material aufweist.

6. Verfahren zum Herstellen des Stapels des piezoelektrischen Bauteils nach einem der Ansprüche 1 bis 5, mit folgenden Verfahrensschritten:
a) Abwechselndes übereinander Anordnen von keramischen Grünfolien und Metallschichten zu einem Grünfolienverbund, wobei in den Grünfolienverbund mindestens eine Ausgangsschicht der Sicherheitsschicht integriert wird, und
b) Wärmebehandeln des Grünfolienverbunds zum monolithischen Stapel, wobei aus den keramischen Grünfolien die Piezokeramikschichten, aus den Metallschichten die Elektrodenschichten, aus der Ausgangsschicht der Sicherheitsschicht die Sicherheitsschicht entstehen und die Infiltrationsbarriere gebildet wird.

7. Verfahren nach Anspruch 6, wobei zum Bilden der Infiltrationsbarriere das Wärmebehandeln unterbrochen wird und folgende weiteren Verfahrensschritte durchgeführt werden:
c) Infiltration von Barriere-Material an einem seitlichen Oberflächenabschnitt des teilweise gesinterten Stapels und
d) Fortführen der Wärmebehandlung, so dass aus dem Barriere-Material die Infiltrationsbarriere gebildet wird.

8. Verfahren nach Anspruch 7, wobei zur Infiltration des Barriere-Materials ein aus der Gruppe Sol-Gel-Verfahren, Schlicker-Verfahren, Sprühen und Tauchen ausgewähltes Verfahren verwendet wird.

9. Verfahren nach Anspruch 6, wobei vor dem übereinander Anordnen der keramischen Grünfolien und der Metallschichten folgende weiteren Verfahrensschritte durchgeführt werden:
e) Bereitstellen einer keramischen Grünfolie und
f) Anordnen der Ausgangsschicht der Sicherheitsschicht.

10. Verfahren nach Anspruch 9, wobei zusätzlich zum Anordnen der Ausgangsschicht der Sicherheitsschicht ein Anordnen einer Vorstufe der Infiltrationsbarriere auf der Grünfolie durchgeführt wird.

11. Verwendung eines piezoelektrischen Bauteils nach einem der Ansprüche 1 bis 5 zum Ansteuern eines Ventils und insbesondere eines Einspritzventils einer Brennkraftmaschine.

## Claims

1. Piezoelectric component (1) with a monolithic stack (10), having,
- electrode layers (102) and piezoceramic layers (101) arranged alternately one on top of the other,
- at least one porous security layer (103) arranged in the stack (10) for the purpose of forming a crack if there is mechanical overload of the stack (10),
**characterised in that**
- arranged between the security layer (103) and a lateral surface layer (107) of the stack (10) is an infiltration barrier (104) for suppressing penetration of a foreign substance into the security layer (103).

2. Component according to claim 1, with the infiltration barrier (104) surrounding the security layer (103).

3. Component according to claim 1 or 2, with the infiltration barrier (104) being arranged in a piezoelectrically-inactive contacting area (105) of the stack (10).

4. Component according to claim 3, with the infiltration barrier (104) having a dimension that is smaller than a dimension of the contacting area (105).

5. Component according to one of claims 1 to 4, with the infiltration barrier (104) featuring a barrier material intrinsic to piezoceramic.

6. Method for producing the stack of the piezoelectric component according to one of claims 1 to 5, with the following process steps:
a) Alternate arrangement one above the other of ceramic green foils and metallic layers to form a green foil composite, with at least one precursor layer of the security layer being integrated into the green foil composite, and
b) Heat treatment of the green foil layer to form a monolithic stack, with the piezoceramic layers being produced from the ceramic green foils, the electrode layers from the metallic layers, the security layer from the precursor layer of the security layer, and the infiltration barrier being formed.

7. Method according to claim 6, with the heat treatment being interrupted for forming the infiltration barrier and the following further method steps being performed;
c) Infiltration of barrier material on a lateral surface section of the partly sintered stack and
d) Continuation of the heat treatment so that the infiltration barrier is formed from the barrier material.

8. Method according to claim 7, with a method selected from the group sol-gel process, slip process, spraying and dipping being used to infiltrate the barrier material.

9. Method according to claim 6, with further method steps being performed before the arrangement of the ceramic green foils and the metallic layers one on top of the other:
e) Provision of a ceramic green foil and
f) Arrangement of the precursor layer of the security layer.

10. Method according to claim 9 with, in addition to the arrangement of the precursor layer of the security layer, an arrangement of a preliminary stage of the infiltration barrier on the green foil is undertaken.

11. Use of a piezoelectric component, according to one of the claims 1 to 5, to actuate a valve and, in particular, an injection valve in an internal combustion engine.

## Revendications

1. Composant piézoélectrique (1) comprenant un empilement monolithique (10), présentant
- des couches d'électrodes (102) disposées les unes sur les autres en alternance et des couches piézocéramiques (101) dotées d'une piézocéramique et
- au moins une couche de sécurité (103) poreuse disposée dans l'empilement (10), pour la formation d'une fissure en cas de surcharge mécanique de l'empilement (10),
**caractérisé en ce qu'**
- entre la couche de sécurité (103) et une section de surface latérale (107) de l'empilement (10) est disposée une barrière d'infiltration (104) destinée à supprimer une pénétration d'une matière étrangère dans la couche de sécurité (103).

2. Composant selon la revendication 1, la barrière d'infiltration (104) entourant la couche de sécurité (103) sur le bord.

3. Composant selon la revendication 1 ou 2, la barrière d'infiltration (104) étant disposée dans une zone de connexion (105), inactive du point de vue piézoélectrique, de l'empilement (10).

4. Composant selon la revendication 3, la barrière d'infiltration (104) présentant une dimension qui est inférieure à une dimension de la zone de connexion (105).

5. Composant selon l'une quelconque des revendications 1 à 4, la barrière d'infiltration (104) présentant une matière barrière de type propre à la piézocéramique.

6. Procédé de fabrication de l'empilement du composant piézoélectrique selon l'une quelconque des revendications 1 à 5, comprenant les étapes de fabrication suivantes :
a) disposition alternante les unes sur les autres de feuilles vertes céramiques et de couches métalliques pour obtenir un assemblageassemblage de feuilles vertes, au moins une couche de départ de la couche de sécurité étant intégrée dans l' assemblage de feuilles vertes et
b) traitement thermique de l' assemblage de feuilles vertes pour obtenir un empilement monolithique, les couches piézocéramiques étant créées à partir des feuilles vertes céramiques, les couches d'électrodes étant créées à partir des couches métalliques, la couche de sécurité et la barrière d'infiltration étant créées à partir de la couche de départ de la couche de sécurité.

7. Procédé selon la revendication 6, le traitement thermique étant interrompu pour la formation de la barrière d'infiltration et les étapes de procédé supplémentaires suivantes étant réalisées :
c) infiltration de matière barrière sur une section de surface latérale de l'empilement fritté en partie et
d) poursuite du traitement thermique de sorte à former la barrière d'infiltration à partir de la matière barrière.

8. Procédé selon la revendication 7, un procédé sélectionné à partir du groupe de procédés sol-gel, de coulage, de pulvérisation et d'immersion étant utilisé pour l'infiltration de la matière barrière.

9. Procédé selon la revendication 6, les étapes de procédé supplémentaires suivantes étant réalisées avant la disposition les unes sur les autres des feuilles vertes céramiques et des couches métalliques:
e) fourniture d'une feuille verte céramique et
f) disposition de la couche de départ de la couche de sécurité.

10. Procédé selon la revendication 9, une disposition d'un stade préliminaire de la barrière d'infiltration étant réalisée sur la feuille verte en plus de la disposition de la couche de départ de la couche de sécurité.

11. Utilisation d'un composant piézoélectrique selon l'une quelconque des revendications 1 à 5, pour la commande d'une soupape et notamment d'une soupape d'injection d'un moteur à combustion.
